# FASCICULE DE BREVET EUROPEEN

(11) **EP 2 774 201 B1**
(45) Date de publication et mention de la délivrance du brevet: **21.06.2023**
(21) Numéro de dépôt: 12780748.5
(22) Date de dépôt: 02.11.2012
(51) Int. Cl.: H01M 8/04, G01R 31/396, H01M 8/04537, G01R 31/3835

(54) **DISPOSITIF DE MESURE DE TENSIONS DANS UNE PILE A COMBUSTIBLE**
VORRICHTUNG ZUR SPANNUNGSMESSUNG IN EINER BRENNSTOFFZELLE
DEVICE FOR MEASURING VOLTAGE IN A FUEL CELL

(30) Priorité: 04.11.2011 FR 1159986
(43) Date de publication de la demande: 10.09.2014
(73) Titulaire: SYMBIO FRANCE, 69200 Vénissieux (FR)
(72) Inventeur: PAGANELLI, Gino, 63040 Clermont-Ferrand Cedex 9 (FR); OLSOMMER, David, 63040 Clermont-Ferrand Cedex 9 (FR)
(74) Mandataire: Lavoix
(86) Numéro de dépôt international: PCT/EP2012/071738
(87) Numéro de publication internationale: WO 2013/064645

(56) Documents cités:
- EP-A1- 1 662 268
- EP-A1- 2 211 412
- EP-A2- 1 411 569
- WO-A1-2008/108979
- WO-A1-2011/136111
- JP-A- 2005 141 936
- US-A- 6 140 820
- US-A1- 2003 048 091
- US-A1- 2005 186 456
- US-A1- 2007 231 641
- US-A1- 2011 217 612

## Description

### DOMAINE DE L'INVENTION

La présente invention concerne le domaine des piles à combustible et notamment les systèmes de surveillance de telles piles. Plus particulièrement, elle se rapporte aux dispositifs de mesure de tensions dans les piles à combustible.

Les piles à combustible connaissent un succès grandissant dans de nombreuses applications. Elles intéressent notamment l'industrie automobile dans le cadre du développement des véhicules électriques, puisqu'elles constituent des générateurs d'électricité propres qui, associés à un réservoir de carburant, offrent une densité d'énergie supérieure aux accumulateurs électrochimiques de type batteries, et présentent un bon rendement.

Dans une pile à combustible, l'électricité est produite par une double réaction chimique : l'oxydation d'un carburant, par exemple de l'hydrogène, sur une électrode, couplée à la réduction d'un comburant, par exemple de l'oxygène, sur une autre électrode. Cette double réaction chimique a lieu au sein d'une cellule comportant généralement une anode et une cathode entre lesquelles est disposée une membrane, formant un ensemble d'électrode à membrane, généralement appelé MEA (de l'anglais Membrane Electrode Assembly). Différents types de membranes peuvent être utilisés, et on connaît par exemple des membranes échangeuses d'ions, ou des membranes à oxyde solide.

### ETAT DE LA TECHNIQUE

Selon les applications, il peut s'avérer nécessaire d'utiliser une pile présentant un empilement plus ou moins grand de cellules, pour fournir la quantité de puissance électrique souhaitée. Par exemple, dans le domaine des véhicules électriques, il n'est pas rare de rencontrer des empilements comportant plus d'une centaine de cellules empilées. Un empilement est donc composé d'un ensemble de MEA, séparés par des plaques bipolaires. Ces plaques comportent un côté anodique et un côté cathodique, qui permettent d'alimenter en gaz les cellules adjacentes de l'empilement. Toutefois, la première et dernière plaques de l'empilement ne sont pas bipolaires, et présentent une seule polarisation. Par abus de langage, un empilement est généralement appelé une pile à combustible, et chaque ensemble MEA est appelé une cellule, ou cellule électrochimique. Ce vocabulaire sera utilisé dans la suite de cette demande.

Dans une pile à combustible utilisée, par exemple, dans une voiture électrique, il est nécessaire de détecter toute anomalie pouvant conduire à un dysfonctionnement ou à un comportement dangereux de la pile. Pour cela, il est utile de pouvoir obtenir des informations individuelles sur chaque cellule, notamment concernant la tension générée.

On connaît, par la demande de brevet US 2011/0217612, un dispositif de mesure comportant plusieurs modules installés directement sur une pile à combustible. Chaque module est destiné à la mesure d'un groupe de cellules, et les différents modules communiquent entre eux par des signaux optiques. Ce dispositif comporte en outre un élément d'agrégation situé à l'extrémité de la pile, destiné à recevoir les mesures effectuées par chaque module.

Un tel dispositif présente de nombreux inconvénients, de par sa configuration. Notamment, les modules sont alimentés par les cellules elles-mêmes, ce qui signifie qu'une perte de tension sur une ou plusieurs cellules conduit à une perte d'alimentation des modules, qui ne sont alors plus en capacité d'effectuer les mesures. Ce dispositif apparaît ainsi inapproprié pour la mesure de très faibles tensions, voire légèrement négatives.

Le document EP 1 411 569 décrit un dispositif de mesure selon le préambule de la revendication 1 et les documents JP 2005-141936, WO2008/108979, US 2007/231641, US 2005/186456 A1 et WO 2011/136111 A1 décrivent d'autres dispositifs de mesure de tensions des cellules d'une pile à combustible.

### BREVE DESCRIPTION DE L'INVENTION

L'invention concerne ainsi un dispositif de mesure de tensions de cellules dans une pile à combustible comportant N cellules électrochimiques séparées par des plaques bipolaires, où N est un entier naturel, le système comprenant :
- au moins deux modules de mesure de tension, chaque module étant capable de mesurer M tensions sur un ensemble de cellules contigües de la pile à combustible, où M est un entier naturel inférieur ou égal à N/2, le groupe de cellules mesurées par le premier module étant adjacent au groupe de cellules mesurées par le deuxième module,
- un calculateur électronique, et
- un bus de communication filaire reliant en série les au moins deux dispositifs de mesure au calculateur,

chacun des modules de mesure comprenant :
   - des moyens mécaniques de fixation du module sur la pile à combustible,
   - des moyens électroniques de mesure de tension,
   - des moyens électriques de connexion des plaques bipolaires à au moins un moyen électronique de mesure de tension,
   - des moyens de connexion des moyens électroniques de mesure de tension au bus de communication,
et chaque module étant conformé pour coopérer avec le module adjacent de façon telle que la dernière plaque bipolaire connectée au premier module est également connectée au deuxième module.

Ainsi qu'il apparaîtra sur les figures illustrant des modes de réalisation de la présente invention, les modules ont une forme présentant un décalage tel qu'une plaque bipolaire située à la frontière de deux modules disposés de manière adjacente, perpendiculairement aux faces latérales des modules, soit connectée à ces deux modules sans recourir à l'utilisation d'une connexion électrique supplémentaire.

En outre, les moyens mécaniques de fixation du module sur la pile à combustible et les moyens électriques de connexion seront confondus. Ainsi, ces moyens comporteront des cosses, par exemple des cosses femelles de type Faston^{®}, permettant d'effectuer à la fois une connexion mécanique et électrique. Ces cosses femelles comportent deux parties métalliques agencées pour enserrer des ergots métalliques formés sur les plaques bipolaires de la pile, et permettant de réaliser la connexion.

Dans une réalisation particulière de l'invention, chaque moyen électronique de mesure de tension mesure les tensions de deux cellules adjacentes. En effet, étant donné la faible épaisseur des cellules électrochimiques d'une pile à combustible, il s'avère peu ergonomique d'installer des moyens pour mesurer les tensions individuelles de chaque cellule. Par ailleurs, on a constaté que la sensibilité des moyens de mesure était suffisante pour qu'une mesure effectuée sur deux cellules permette de rendre compte de l'état de chacune des cellules. Ainsi, dans un mode de réalisation particulier, un module effectue huit mesures de tension pour un ensemble de seize cellules.

Dans une réalisation particulière de l'invention, le bus de communication filaire est un bus série de type CAN^{®} (Control Area Network), présentant des caractéristiques de robustesse utiles dans le cadre d'un dispositif tel que celui de la présente invention. Dans une autre réalisation particulière, un bus de type I2C est utilisé.

Par ailleurs, dans une autre réalisation particulière de l'invention, le dispositif de mesure comprend au moins un dispositif d'isolation galvanique entre le bus de communication filaire et la pile à combustible. Un tel dispositif comprend, par exemple, un optocoupleur. En effet, la pile à combustible est constituée de cellules connectées en série ; en fonction de sa position sur la pile à combustible, chaque module de mesure se trouve donc à un potentiel différent par rapport à la polarité négative de la pile à combustible. Il convient donc de réaliser une isolation galvanique entre les moyens de mesure et le bus de communication commun.

Dans une autre réalisation particulière de l'invention, chaque module de mesure de tension comporte une adresse, ou codage, différent des autres modules. En effet, ainsi qu'expliqué ultérieurement, ceci permet au calculateur électronique d'adresser les requêtes par lesquelles des mesures sont demandées aux différents modules.

Le calculateur électronique est utilisé pour gérer les mesures effectuées par le dispositif Pour cela, il communique avec les modules via le bus de communication filaire, et reçoit les résultats des mesures par le même biais. Dans la suite de la demande, ce calculateur sera dénommé contrôleur, sans toutefois restreindre la portée du terme à un type spécifique de composant.

### BREVE DESCRIPTION DES FIGURES

D'autres objectifs et avantages de l'invention apparaîtront clairement dans la description qui va suivre d'un mode de réalisation préféré mais non limitatif, illustré par les figures suivantes dans lesquelles :
- la figure 1 représente schématiquement l'installation de deux modules de mesure sur une pile à combustible,
- la figure 2 représente un schéma fonctionnel d'un module utilisé dans le cadre d'un dispositif selon l'invention,
- la figure 3 représente un dispositif selon l'invention comportant quatre modules de mesure, et
- la figure 4 représente une vue éclatée d'une installation telle que montrée en figure 1.

### DESCRIPTION DU MEILLEUR MODE DE REALISATION DE L'INVENTION

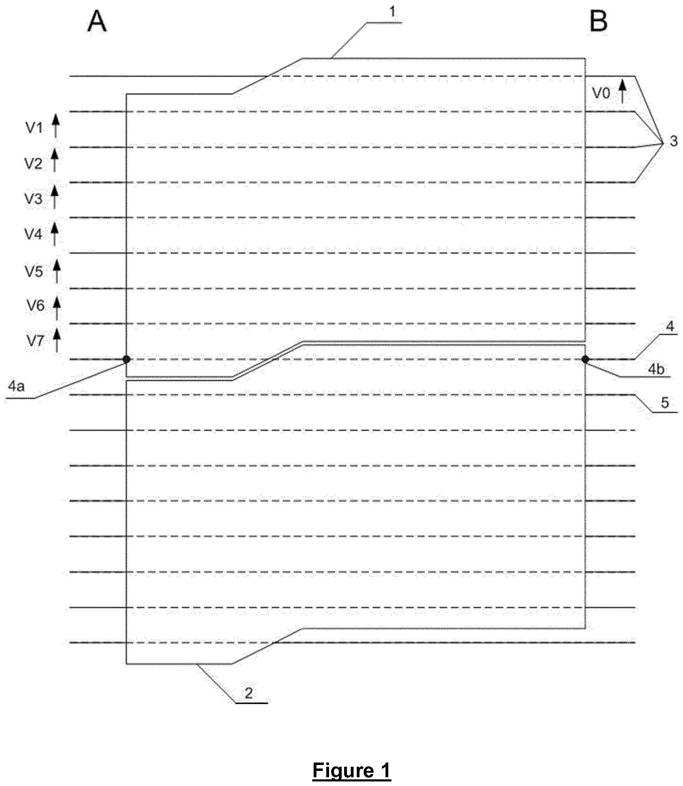

La figure 1 représente un dispositif selon un mode de réalisation particulier de l'invention. Ce dispositif comprend un premier module de mesure de tension 1, et un deuxième module de mesure de tension 2, installés sur une pile à combustible. La pile est représentée en vue de dessus, et seules apparaissent les plaques bipolaires 3 séparant les différentes MEA de l'empilement. Sur la figure, seules quatre plaques portent la référence 3, mais on comprend que chaque trait horizontal portant une mesure de tension représente une plaque bipolaire. Il est à noter que, dans cet exemple particulier de l'invention, les mesures de tension ne sont pas effectuées sur chaque cellule, mais sur des groupes de deux cellules contiguës. Par mesure de simplification, on a représenté sur la figure 1 uniquement les plaques bipolaires aux bornes desquelles sont effectuées les mesures de tension, c'est-à-dire une plaque sur deux par rapport à l'empilement complet.

Le premier module est utilisé pour effectuer huit mesures de tensions V0 à V7, couvrant ainsi seize cellules. A cet effet, le module de mesure doit être connecté à au moins neuf plaques bipolaires, ainsi que montré sur cette figure. Dans cet exemple de réalisation particulier, les connexions métalliques utilisées pour le maintien en position du module sur la pile à combustible servent également de connexions électriques. Ainsi que montré sur cette figure, le module de mesure est connecté à chaque plaque bipolaire par l'intermédiaire de deux connexions : une située côté gauche, dans la zone A, l'autre située côté droit, dans la zone B, à l'exception de la première et de la dernière plaque connectées. Ceci conduit à une redondance de la mesure des tensions V1 à V7. Toutefois, cette redondance est également de nature mécanique, et permet ainsi d'assurer une bonne stabilité à l'ensemble.

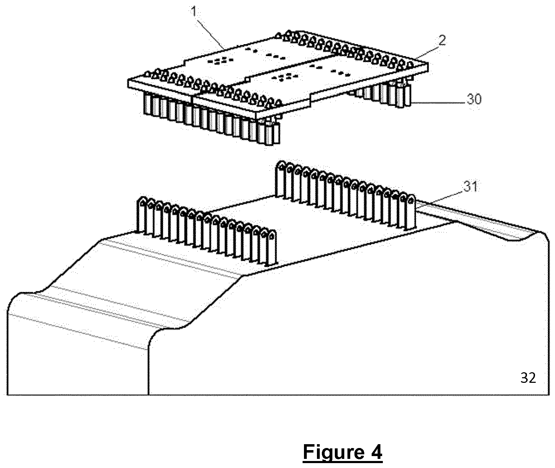

La figure 4 montre un exemple de réalisation d'un dispositif de mesure comportant deux modules 1 et 2, destiné à être installé sur une pile à combustible 32. Dans cet exemple particulier, les moyens de connexions des modules sont des cosses métalliques 30, de type Faston. Les plaques bipolaires sont munies de d'ergots métalliques 31, permettant d'établir la connexion avec les cosses. De manière avantageuse, une plaque bipolaire comporte deux ergots métalliques.

En outre, on constate, sur la figure 1, que la forme du premier et deuxième modules 1 et 2 est telle que la plaque bipolaire 4 est connectée à la fois au premier module, au niveau de la connexion 4a, et au deuxième module, au niveau de la connexion 4b. Grâce à cette forme, la tension entre les plaques 4 et 5 peut être mesurée sans recourir à une quelconque connexion supplémentaire entre les modules 1 et 2. En effet, si les modules étaient de forme rectangulaire, la plus grande longueur d'un module située parallèlement aux plaques, la plaque bipolaire 4 ne serait connectée qu'à un seul module, par exemple le module 1. Dans ce cas, pour mesurer la tension entre les plaques 4 et 5, il serait nécessaire d'établir une connexion filaire pour transmettre le potentiel de la plaque 4 au module 2 qui effectuerait la mesure, ou pour transmettre le potentiel de la plaque 5 au module 1 qui effectuerait dans ce cas la mesure.

Un tel dispositif présente de nombreux avantages en termes de fiabilité, de simplicité d'installation et d'utilisation et d'économie. En effet, chaque module est destiné à mesurer les tensions aux bornes d'un petit nombre de cellules, par exemple seize. L'espacement entre les connexions des modules est donné par l'épaisseur des cellules ; Or, selon la construction de la pile à combustible et en fonction de la température et de la pression de serrage de l'ensemble, l'épaisseur peut varier, et peut conduire, sur la totalité de l'empilement, à une variation totale empêchant l'installation d'un dispositif de mesure de taille prédéterminée. En revanche, sur un ensemble de seize cellules, la variation totale n'atteint jamais une valeur telle qu'un module selon une réalisation de l'invention ne puisse être installé. Par ailleurs, un tel module est simple et économique en ce que les connexions électriques et mécaniques sont effectuées par un unique élément. En outre, la forme particulière des modules évite l'installation de connexions filaires entre les modules du dispositif, simplifiant ainsi son installation et évitant toute déconnexion intempestive à ce niveau.

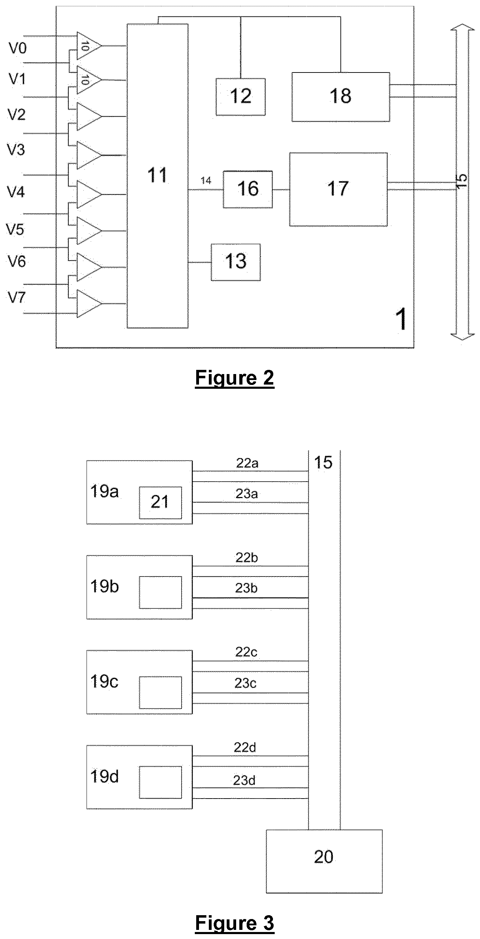

Le fonctionnement d'un module va maintenant être décrit en référence à la figure 2 qui montre un exemple d'architecture fonctionnelle du module 1 utilisé dans un dispositif selon l'invention. Par mesure de simplification, sur cette figure sont représentées uniquement les entrées du côté A.

Le module 1 est connecté à neuf plaques bipolaires, ce qui permet de procéder à la mesure de huit tensions V0 à V7. Ces mesures sont effectuées par huit montages à amplificateur opérationnel 10. Ces tensions sont ensuite transmises à un convertisseur analogique / numérique 11. Ce convertisseur est relié à une valeur de référence 12 égale par exemple à 2,5 volts, permettant de comparer les mesures transmises par les montages 10.

Le convertisseur analogique / numérique 11 ne peut convertir que des tensions positives. Or, il est souhaitable, dans un mode de réalisation de l'invention, de pouvoir mesurer également des tensions négatives, qui permettent de détecter une inversion d'une cellule, notamment dû à une sous-alimentation en hydrogène. Pour remédier à cela, le convertisseur 11 est également relié à un dispositif 13 permettant l'application d'une tension de décalage sur les tensions mesurées, avant la conversion.

Une fois la conversion d'une mesure effectuée, le résultat est transmis à un bus de données 14. Ce bus est, par exemple, un bus série de type I2C (Inter Integrated Circuit), ou de type CAN^{®}. Ce bus de données 14 achemine les données à un second bus de données 15, qui achemine ensuite les données jusqu'à un contrôleur général 20 (voir Figure 3). Dans le cas où les bus 14 et 15 ne sont pas de même type, il est utile de prévoir un microcontrôleur 16, permettant de convertir les données sous un format supporté par le bus 15. Par ailleurs, afin d'éviter que les hautes tensions présentes au niveau de la pile à combustible ne se propagent sur le bus 15 et endommagent certains composants, il est utile de disposer d'un dispositif d'isolation galvanique 17, par exemple un optocoupleur.

L'ensemble du module 1 est alimenté par le bus 15. A cet effet, un convertisseur tension/tension 18 est installé dans le module, et relié aux principaux composants. Ce convertisseur comprend également, dans une réalisation préférentielle, un dispositif d'isolation galvanique pour éviter le problème précédemment mentionné.

Un module tel que montré sur la figure 2 est destiné à être utilisé dans un dispositif dont un exemple est montré en figure 3.

Ce dispositif comprend quatre modules 19a, 19b, 19c et 19d. Chacun des modules est connecté au bus 15 qui les relie au contrôleur 20. Le nombre de modules est donné ici à titre d'exemple et n'est pas limitatif. Un dispositif à quatre modules permet, dans le cas où on utilise un convertisseur à huit entrées, de mesurer trente-deux tensions. Il est donc utilisable sur une pile à soixante-quatre cellules dans le cas où les tensions de cellules sont mesurées par groupe de deux cellules. Chacun des modules dispose d'une adresse 21 permettant de le distinguer. Par exemple, cette adresse est codée sur trois bits à trois états et est physiquement inscrite sur chaque module par l'utilisation de points de soudure permettant d'effectuer des liaisons électriques représentant chacun des bits.

Le contrôleur 20 est l'organe qui gère le fonctionnement du dispositif de mesure, et notamment qui commande les mesures. En effet, les mesures de tension ne sont pas transmises en permanence au contrôleur, mais uniquement sur requête.
En l'absence de requête, les modules prélèvent sur le bus 15, via les liaisons correspondantes 22a, 22b, 22c et 22d, uniquement un courant de maintien leur permettant de recevoir les requêtes et de déterminer s'ils sont concernés. En revanche, en l'absence de requête, le convertisseur 11 n'est pas activé, donc aucune conversion n'est effectuée.
Lorsqu'une mesure est nécessaire, le contrôleur 20 envoie dans un premier temps une requête sur le bus, comprenant l'adresse du module et la position de la cellule dont on souhaite recevoir la tension. A réception de la requête, le module adressé sort de son état de veille, et prélève un courant supérieur sur le bus 15.
Il procède alors à une lecture de la valeur précédemment convertie et stockée au niveau du convertisseur 11, puis déclenche une nouvelle conversion, destinée à être utilisée lors d'une requête ultérieure. La valeur lue est alors transférée sur le bus 15 via la liaison correspondante parmi les liaisons 23a à 23d, puis communiquée au contrôleur 20.

Le contrôleur 20 de la pile est ainsi en capacité, en fonction des mesures reçues, de déterminer que les tensions ne sont pas figées, et qu'elles ne se situent pas en dehors du domaine de fonctionnement classique. Si un défaut est détecté, il peut être utile d'arrêter la pile pour éviter tout dysfonctionnement dangereux.

Un dispositif selon l'invention répond donc bien aux exigences de simplicité et de fiabilité requises. En effet, le bus 15 sert à la fois à la communication des données et à l'alimentation des modules, ce qui permet de poursuivre les mesures même en cas de dysfonctionnements de la pile.

## Revendications

1. Dispositif de mesure de tensions de cellules dans une pile à combustible comportant N cellules électrochimiques séparées par des plaques bipolaires, où N est un entier naturel, le dispositif comprenant :
- au moins deux modules de mesure de tension (1,2), chaque module étant capable de mesurer M tensions sur un ensemble de cellules contigües de la pile à combustible (32), où M est un entier naturel inférieur ou égal à N/2, le groupe de cellules mesurées par le premier module étant adjacent au groupe de cellules mesurées par le deuxième module,
- un calculateur électronique, et
- un bus de communication filaire reliant en série les au moins deux dispositifs de mesure au calculateur,
chacun des modules de mesure comprenant :
- des moyens mécaniques de fixation du module sur la pile à combustible (30),
- des moyens électroniques de mesure de tension,
- des moyens électriques de connexion des plaques bipolaires à au moins un moyen électronique de mesure de tension,
- des moyens de connexion des moyens électroniques de mesure de tension au bus de communication,
et chaque module (1) étant conformé pour coopérer avec le module adjacent (2) de façon telle que la dernière plaque bipolaire connectée au premier module est également connectée au deuxième module,
**caractérisé en ce que** :
- les moyens mécaniques de fixation du module sur la pile à combustible et les moyens électriques de connexion sont confondus ; et
- les moyens électriques de connexion comportent des cosses (30) capables de servir également de moyens mécaniques de fixation et sont agencés pour coopérer avec des ergots métalliques dont sont munies les plaques bipolaires (31).

2. Dispositif de mesure selon la revendication 1, dans lequel chaque moyen électronique de mesure de tension mesure les tensions de deux cellules adjacentes.

3. Dispositif de mesure selon la revendication 1 ou 2, dans lequel les cosses sont des cosses femelles, comportant deux parties métalliques agencées pour enserrer les ergots métalliques, permettant de réaliser la connexion mécanique et électrique.

4. Dispositif de mesure selon l'une des revendications précédentes, comprenant en outre au moins un dispositif d'isolation galvanique entre le bus de communication filaire et la pile à combustible.

5. Dispositif de mesure selon la revendication 4, dans lequel le dispositif d'isolation galvanique comprend un optocoupleur.

6. Dispositif de mesure selon l'une des revendications précédentes, dans lequel chaque module de mesure de tension comporte une adresse différente des autres modules.

7. Dispositif de mesure selon l'une des revendications précédentes, dans lequel M est égal à 8.

## Patentansprüche

1. Vorrichtung zum Messen von Zellspannungen in einer Brennstoffzelle, umfassend N elektrochemische Zellen, die durch bipolare Platten getrennt sind, wobei N eine natürliche Zahl ist, die Vorrichtung umfassend:
- mindestens zwei Spannungsmessmodule (1, 2), wobei jedes Modul in der Lage ist, M Spannungen an einer Gruppe von benachbarten Zellen der Brennstoffzelle (32) zu messen, wobei M eine natürliche Zahl kleiner als oder gleich wie N/2 ist, wobei die Gruppe von Zellen, die durch das erste Modul gemessen werden, an die Gruppe von Zellen angrenzt, die durch das zweite Modul gemessen werden,
- einen elektronischen Rechner, und
- einen drahtgebundenen Kommunikationsbus, der die mindestens zwei Messvorrichtungen in Reihe mit dem Rechner verbindet,
jedes der Messmodule umfassend:
- mechanische Befestigungseinrichtungen des Moduls an der Brennstoffzelle (30),
- elektronische Spannungsmesseinrichtungen,
- elektrische Einrichtungen zur Verbindung der Bipolarplatten mit mindestens einer elektronischen Spannungsmesseinrichtung,
- Verbindungeinrichtungen der elektronischen Spannungsmesseinrichtungen mit dem Kommunikationsbus,
und wobei jedes Modul (1) geformt ist, um mit dem benachbarten Modul (2) zusammenzuwirken, sodass die letzte bipolare Platte, die mit dem ersten Modul verbunden ist, auch mit dem zweiten Modul verbunden ist,
**dadurch gekennzeichnet, dass**:
- die mechanischen Befestigungseinrichtungen des Moduls an der Brennstoffzelle und die elektrischen Verbindungseinrichtungen ineinander übergehen; und
- die elektrischen Verbindungseinrichtungen Kabelschuhe (30) umfassen, die auch als mechanische Befestigungseinrichtungen dienen können und angeordnet sind, um mit Metallnasen zusammenzuwirken, mit denen die Bipolarplatten (31) versehen sind.

2. Messvorrichtung nach Anspruch 1, wobei jede elektronische Spannungsmesseinrichtung die Spannungen von zwei benachbarten Zellen misst.

3. Messvorrichtung nach Anspruch 1 oder 2, wobei die Kabelschuhe Buchsenkabelschuhe sind, umfassend zwei Metallteile, die angeordnet sind, um die Metallstifte zu umschließen, wodurch die mechanische und elektrische Verbindung hergestellt werden kann.

4. Messvorrichtung nach einem der vorherigen Ansprüche, ferner umfassend mindestens eine Vorrichtung zur galvanischen Trennung zwischen dem drahtgebundenen Kommunikationsbus und der Brennstoffzelle.

5. Messvorrichtung nach Anspruch 4, wobei die Vorrichtung zur galvanischen Trennung einen Optokoppler umfasst.

6. Messvorrichtung nach einem der vorherigen Ansprüche, wobei jedes Spannungsmessmodul eine Adresse aufweist, die sich von den anderen Modulen unterscheidet.

7. Messvorrichtung nach einem der vorherigen Ansprüche, wobei M gleich wie 8 ist.

## Claims

1. A device for measuring cell voltages in a fuel cell having N electrochemical cells separated by bipolar plates, where N is a natural number, the device comprising:
- at least two voltage measurement modules (1,2), each module being capable of measuring M voltages on a set of contiguous cells of the fuel cell (32), where M is a natural number less than or equal to N/2, the group of cells measured by the first module being adjacent the group of cells measured by the second module,
- an electronic computer, and
- a wired communication bus connecting the at least two measuring devices to the computer in series,
each of the measurement modules comprising:
- mechanical means for attaching the module to the fuel cell (30),
- electronic means of voltage measurement,
- electrical means for connecting the bipolar plates to at least one electronic voltage measuring means,
- means for connecting the electronic voltage measurement means to the communication bus,
and each module (1) being shaped to cooperate with the adjacent module (2) in such a way that the last bipolar plate connected to the first module is also connected to the second module,
**characterised in that**:
- the mechanical means of attaching the module to the fuel cell and the electrical means of connection are merged; and
- the electrical connection means comprise lugs (30) capable of serving also as mechanical fastening means and are arranged to cooperate with metal pins with which the bipolar plates (31) are provided.

2. The measuring device of claim 1, wherein each electronic voltage measuring means measures the voltages of two adjacent cells.

3. The measuring device according to claim 1 or 2, wherein the lugs are female lugs, having two metal parts arranged to grip the metal lugs, allowing the mechanical and electrical connection to be made.

4. A measuring device according to any of the preceding claims, further comprising at least one galvanic isolation device between the wired communication bus and the fuel cell.

5. The measuring device of claim 4, wherein the galvanic isolation device comprises an optocoupler.

6. A measuring device according to any of the preceding claims, wherein each voltage measuring module has a different address from the other modules.

7. A measuring device according to any of the preceding claims, wherein M is equal to 8.
